# EUROPEAN PATENT SPECIFICATION

(11) **EP 3 998 840 B1**
(45) Date of publication and mention of the grant of the patent: **21.06.2023**
(21) Application number: 19946955.2
(22) Date of filing: 09.12.2019
(51) Int. Cl.: H05B 6/66

(54) **MICROWAVE OVEN**
MIKROWELLENOFEN
FOUR À MICRO-ONDES

(30) Priority: 24.09.2019 CN 201910906612
(43) Date of publication of application: 18.05.2022
(73) Proprietor: Guangdong Midea White Home Appliance Technology Innovation Center Co., Ltd., Foshan, Guangdong 528311 (CN); Midea Group Co., Ltd., Foshan, Guangdong 528311 (CN)
(72) Inventor: HU, Jian, Foshan City, Guangdong 528311 (CN); YE, Chengkai, Foshan City, Guangdong 528311 (CN); HOU, Junfeng, Foshan City, Guangdong 528311 (CN); SHI, Zhixiong, Foshan City, Guangdong 528311 (CN)
(74) Representative: Whitlock, Holly Elizabeth Ann
(86) International application number: PCT/CN2019/124120
(87) International publication number: WO 2021/056834

(56) References cited:
- CN-A- 105 253 781
- CN-A- 105 253 781
- CN-A- 107 191 980
- CN-U- 206 302 344
- CN-U- 206 302 344
- KR-A- 20100 012 243
- US-A- 4 977 301

## Description

### TECHNICAL FIELD

The described embodiments relate to the field of electric appliances, and in particular, to a microwave oven.

### BACKGROUND

Electromagnetic compatibility (EMC) of electric appliances is a very important quality index, which is not only related to operational reliability and use safety of electric appliances, but also affects a normal operation of other equipment and systems. Therefore, microwave ovens must pass the EMC standards before being released into the market.

During a long period of research and development, inventors of the present disclosure found that the microwave ovens currently on the market are mainly divided into power frequency microwave ovens and variable frequency microwave ovens. The power frequency microwave ovens use commercial frequency transformers to boost voltage, while the variable frequency microwave ovens use frequency conversion technology and convert commercial power into high voltage at high frequencies. The variable frequency microwave ovens use frequency converters to replace the commercial frequency transformers of the power frequency microwave ovens, so that volumes and weights of the microwave ovens have been significantly reduced, and the microwave ovens are widely popular with consumers.

However, a plurality of electronic components are used in the existing variable frequency microwave ovens due to the arrangement of the frequency converters, resulting in serious EMC problems. For example, severe attenuation vibration is generated at the moment when high current of a switch tube is turned off, and a spike voltage is generated by reverse recovery characteristics of a diode, and both include electromagnetic interference with rich spectrum, which is emitted to a surrounding space through a wiring harness connected to the switch tube or the diode to form Radiated Emission (RE).

From each of US 4 977 301 A and CN 206 302 344 U a microwave oven is known, comprising a frequency converter, a magnetron, a first conductor connected to a power supply end of the magnetron, and a second conductor connected to a ground end of the magnetron.

### SUMMARY

The technical problem to be solved by the present disclosure is how to reduce the RE of the microwave oven to make the microwave oven meet the EMC standards.

In order to solve the above technical problem, a technical solution of the present disclosure may provide a microwave oven. The microwave oven includes a frequency converter, a magnetron, a first conductor, and a second conductor; a power supply end of the frequency converter is connected to a power supply end of the magnetron via the first conductor, and a ground end of the frequency converter is connected to a ground end of the magnetron via the second conductor; the first conductor and a part of the second conductor are arranged in parallel, and a distance between the first conductor and the part of the second conductor is less than a preset distance.

In one embodiment, a housing of the magnetron is grounded, the ground end of the magnetron is connected to the housing of the magnetron, and the ground end of the frequency converter is connected to the housing of the magnetron via the second conductor.

In one embodiment, the second conductor includes a first section, the first section of the second conductor is routed from the ground end of the frequency converter to the power supply end of the frequency converter; and a second section, the ground end of the frequency converter is connected to the second section of the second conductor via the first section of the second conductor, and the second section of the second conductor arranged in parallel to the first conductor.

In one embodiment, the ground end of the frequency converter is grounded, the ground end of the magnetron is connected to a housing of the magnetron, and the housing of the magnetron is connected to the ground end of the frequency converter via the second conductor.

In one embodiment, the second conductor includes a first section, the first section of the second conductor is arranged in parallel to the first conductor; and a second section, the second section of the second conductor is routed from the power supply end of the frequency converter to the ground end of the frequency converter, and the housing of the magnetron is connected to the second section of the second conductor via the first section of the second conductor.

In one embodiment, the housing of the magnetron is arranged with a ground point, and the ground end of the frequency converter is connected to the ground point via the second conductor.

In one embodiment, the power supply end of the magnetron is arranged on a first side of the magnetron, the ground point is arranged on a second side of the magnetron, the ground end of the frequency converter is arranged on a first side of the frequency converter, and the power supply end of is arranged on a second side of the frequency converter; a third side of the magnetron is arranged opposite to the second side of the frequency converter, the first side of the magnetron and the first side of the frequency converter are arranged on a same side, and the second side of the magnetron is arranged opposite to the third side of the magnetron.

In one embodiment, a sleeve is sleeved on the first conductor.

In one embodiment, the first conductor and the second conductor are bound with each other.

In one embodiment, the distance between the first conductor and the part of the second conductor is less than a distance between the power supply end of the frequency converter and the ground end of the frequency converter.

Different from the related art, the present disclosure has the following beneficial effects: the microwave oven according to some embodiments of the present disclosure includes a frequency converter, a magnetron, a first conductor, and a second conductor; a power supply end of the frequency converter is connected to a power supply end of the magnetron via the first conductor, and a ground end of the frequency converter is connected to a ground end of the magnetron via the second conductor. The first conductor and a part of the second conductor are arranged in parallel, and a distance between the first conductor and the part of the second conductor is less than a preset distance. In this way, the first conductor as a cathode wire and the part of the second conductor as a ground wire are arranged in parallel in some embodiments of the present disclosure, so as to reduce a distance between the cathode wire and the ground wire, and then reduce an area of a closed loop formed by the cathode wire and the ground wire, thus reducing the RE of the microwave oven to make the microwave oven meet the EMC standards.

### BRIEF DESCRIPTION OF THE DRAWINGS

FIG 1 is a structural view of a microwave oven according to an embodiment of the present disclosure.
FIG 2 is a structural view of a microwave oven.
FIG 3 is a structural view of a microwave oven according to an embodiment of the present disclosure.
FIG 4 is a structural view of a microwave oven according to an embodiment of the present disclosure.
FIG 5 is a view of RE test results of the microwave oven in the embodiment of FIG 4.
FIG 6 is a view of RE test results of the microwave oven as shown in FIG 2.
FIG 7 is a structural view of a microwave oven according to an embodiment of the present disclosure.
FIG 8 is a structural view of a microwave oven according to an embodiment of the present disclosure.

### DETAILED DESCRIPTION

Technical solutions of the embodiments of the present disclosure may be described in detailed by referring to accompanying figures of the embodiments. Obviously, embodiments to be described are only a part of, but not all of, the embodiments of the present disclosure. Any ordinary skilled person in the art may obtain other embodiments without any creative work, and the other embodiments should be included in the scope of the present disclosure.

In order to suppress the RE of the microwave oven, a magnetic ring is usually applied to the microwave oven by an ordinary skilled person in the art. In this way, the RE is shielded via the magnetic ring, so as to reduce leakage. However, material cost and production cost of the magnetic ring are higher, and a shield effect of the magnetic ring on the RE is not obvious, which cannot suppress full-band electromagnetic wave. Meanwhile, disturbance characteristics of the microwave ovens with different batches are various due to different types, and it is necessary to make different magnetic rings according to the RE test, thus technical versatility is low.

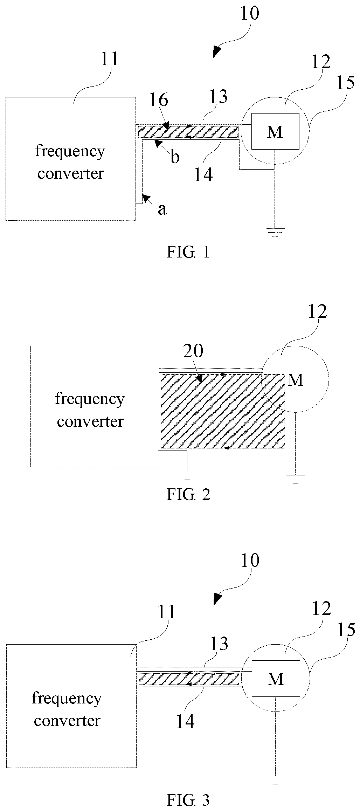

Therefore, in some embodiments of the present disclosure, a microwave oven is provided, the microwave oven has high versatility and low cost, and the RE of the microwave oven is very small, which can meet the EMC standards. As shown in FIG 1, FIG.1 is a structural view of the microwave oven according to an embodiment of the present disclosure. In some embodiments, the microwave oven 10 includes a frequency converter 11, a magnetron 12, a first conductor or conductive wire 13, and a second conductor or conductive wire 14. A power supply end (not shown) of the frequency converter 11 is connected to a power supply end (not shown) of the magnetron 12 via the first conductor 13, and a ground end (not shown) of the frequency converter 11 is connected to a ground end (not shown) of the magnetron 12 via the second conductor 14. The first conductor 13 and a part of the second conductor 14 are arranged in parallel, and a distance between the first conductor 13 and the part of the second conductor 14 is less than a preset distance.

In some embodiments, the frequency converter 11 may be a single-phase, a triple-phase, a high frequency converter, a general frequency converter, or the like. The frequency converter 11 at least includes a rectifier (not shown), a filter (not shown), an inverter (not shown). The frequency converter 11 is configured to cause a change in power of a power supply for voltage regulation and frequency modification, so that the frequency converter 11 outputs electrical energy of different values to the magnetron 12, and the magnetron 12 is driven to output microwaves of different energy levels. In this way, the microwave oven 10 may output powers of different sizes according to environmental conditions or users' needs, thus achieving the purpose of energy saving.

The magnetron 12 is configured for generation and emission of microwave energy during a heating process of the microwave oven 10. In this embodiment, the magnetron 12 may be a continuous-wave magnetron, pulse-wave magnetron, or the like. The magnetron 12 at least includes an antenna (not shown), a cathode (not shown), and an anode (not shown). Further, the cathode used as a power supply end is configured to obtain electrical signals from the power supply end of the frequency converter 11 and emit electrons to the anode. The electrons are received by the anode to generate an anode current, and the power is further transmitted to the antenna. In this way, the antenna sends the microwaves to the microwave oven 10, so that food in the microwave oven can be heated.

The power supply end of the magnetron 12 is the cathode of the magnetron 12, therefore, the first conductor 13 is usually referred to as a cathode wire. In this embodiment, the first conductor 13 includes two cathode wires (not shown). The second conductor 14 is a ground wire, and is configured to connect the ground end of the frequency converter 11 to the ground end of the magnetron 12. The anode of the magnetron 12 is connected to the ground end of the magnetron 12.

In an application scenario, a voltage between the two cathode wires of the magnetron 12 is 3.3V, and configured to heat the magnetron 12, so that the electrons can be excited more easily. Further, a voltage between the cathode wire and the ground end is 4kV, and configured to convert the electrical energy into the microwave energy.

According to an antenna theory, a closed loop with current flowing through can emit electromagnetic energy to the surrounding space due to an antenna effect. A radiated power can be regarded as a power loss of the current in a resistance, and the resistance is called as a radiation resistance (which represents an ability to radiate the electromagnetic energy), that is to say, P=I^{2∗}R_{rad}, where P is a total radiation power of the antenna, I is a feed current of the antenna, and R_{rad} is the radiation resistance. Further, the larger the R_{rad}, the stronger the antenna radiation capacity. When a circumference (C) of the antenna is less than or equal to 5λ (C ≤ 5λ), the radiation resistance (R_{rad}) is equal to 320π^{4∗}S²/λ⁴, where λ is a wavelength corresponding to an electromagnetic frequency, and S is an area of the antenna.

For the microwave oven 10, an electromagnetic frequency band of the RE is about 30MHz to 1GHz. The closed loop in the microwave oven 10 basically meets requirements of the circumference of the antenna as described above. Therefore, the larger the area of the closed loop, the stronger the ability to radiate the electromagnetic energy. A largest closed loop in the microwave oven 10 is formed by the cathode wire and the ground wire, that is to say, the closed loop 16 formed by the first wire 13 and the second wire 14.

During a long period of research and development, inventors of the present disclosure found that there is a long distance between the frequency converter 11 and the magnetron 12 in a hardware configuration of the microwave oven 10, so that there is a great distance between the ground end of the frequency converter 11 and the ground end of the magnetron 12, and there is also a long distance between the power supply end of the frequency converter 11 and the ground end of the frequency converter 11. Based on the hardware configuration, if the ground end of the frequency converter 11 and the ground end of the magnetron 12 are grounded closely or nearby, an area of a closed loop 20 formed by the cathode wire and the ground wire will be larger, and the microwave oven 10 has a stronger ability to radiate electromagnetic energy into space, as shown in FIG 2.

Compared with the largest closed loop 20 in the microwave oven as shown in FIG 2, the area of the largest closed loop 16 in the microwave oven 10 in the embodiment of FIG 1 is significantly reduced.

Therefore, in the embodiment, the first conductor 13 used as the cathode wire and the second conductor 14 used as the ground wire are arranged in parallel. In this way, the distance between the cathode wire and the ground wire is reduced, so as to reduce the area of the closed loop 16 formed by the cathode wire and the ground wire, so that the RE of the microwave oven 10 is reduced, thus making the microwave oven 10 meet the EMC standards.

Referring to FIG 1, in the embodiment, the second conductor 14 includes a first section a and a second section b, the ground end of the frequency converter 11 is connected to the second section b of the second conductor 14 via the first section a of the second conductor 14, the first section a of the second conductor 14 is routed from the ground end of the frequency converter 11 to the power supply end of the frequency converter 11, and the second section b of the second conductor 14 is arranged in parallel to the first conductor 13.

Furthermore, a distance between the first conductor 13 and the part of the second conductor 14, that is between the first conductor 13 and the second section b of the second conductor 14, is less than a distance between the power supply end of the frequency converter 11 and the ground end of the frequency converter 11.

In this way, it is possible to reduce a distance between a current path, between the power supply end of the frequency converter 11 in the closed loop 16 and the power supply end of the magnetron 12, and a current path, between the ground end of the frequency converter 11 and the ground end of the magnetron 12, thus reducing the area of the closed loop 16.

In some embodiments, in order to reduce the distance between the first conductor 13 and the second section b of the second conductor 14 as much as possible, the first conductor 13 and the second conductor 14 may be bound with each other via a lace (not shown) or a sleeve (not shown). It should be understood that, in other embodiments, the first conductor and the second conductor may be bound with each other via other ways, such as by means of pasting, and the like.

In some embodiments, in order to prevent an insulation layer outside the first conductor 13 and/or an insulation layer outside the second conductor 14 from being worn or cracked, which may cause a short circuit between the first conductor 13 and the second conductor 14, a sleeve (not shown) may be further sleeved on a periphery of the first conductor 13.

In this embodiment, the ground end of the frequency converter 11 is connected to the ground end of the magnetron 12, and the ground end of the magnetron 12 is grounded.

In another embodiment, as shown in FIG 3, a difference between the microwave oven 10 of this embodiment and the microwave oven 10 as shown in FIG 1 is that the ground end of the magnetron 12 is connected to a housing 15 of the magnetron 12, the ground end of the frequency converter 11 is connected to the housing 15 of the magnetron 12 via the second conductor 14, and the housing 15 of the magnetron 12 is connected to a case (not shown) of the microwave oven 10 so as to be grounded.

In this way, the second conductor 14 may be connected closely to the housing 15 of the magnetron 12, so as to reduce a length of the second conductor 14.

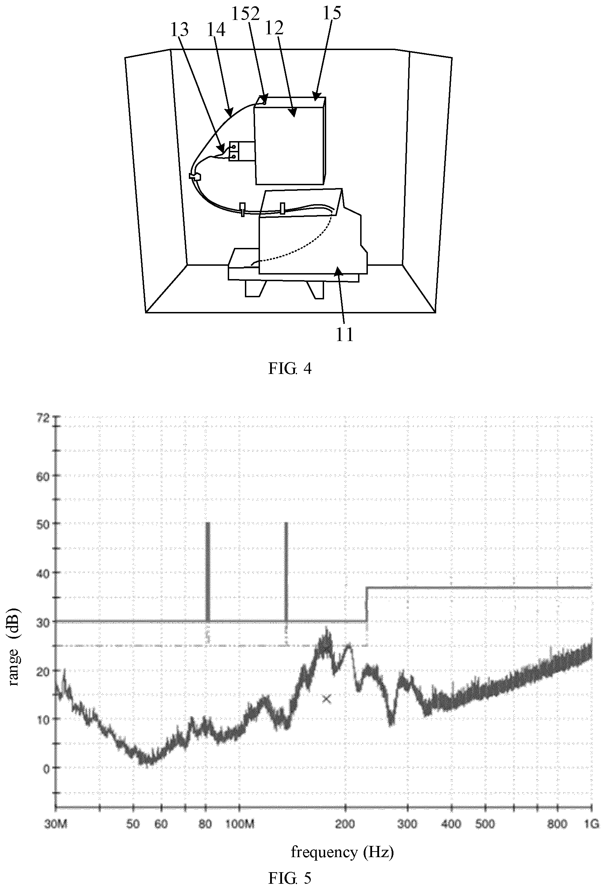

In another embodiment, as shown in FIG 4, a difference between the microwave oven 10 of this embodiment and the microwave oven 10 as shown in FIG 3 is that the housing 15 of the magnetron 12 is arranged with a ground point 152 and the ground end of the frequency converter 11 is connected to the ground point 152 via the second conductor 14.

In some embodiments, the power supply end of the magnetron 12 is arranged on a first side of the magnetron 12, and the ground point 152 is arranged on a second side of the magnetron 12. The ground end of the frequency converter 11 is arranged on a first side of the frequency converter 11, and the power supply end of the frequency converter 11 is arranged on a second side of the frequency converter 11. Furthermore, a third side of the magnetron 12 is arranged opposite to the second side of the frequency converter 11, the first side of the magnetron 12 and the first side of the frequency converter 11 are arranged on a same side, and the second side of the magnetron 11 is arranged opposite to the third side of the magnetron 12.

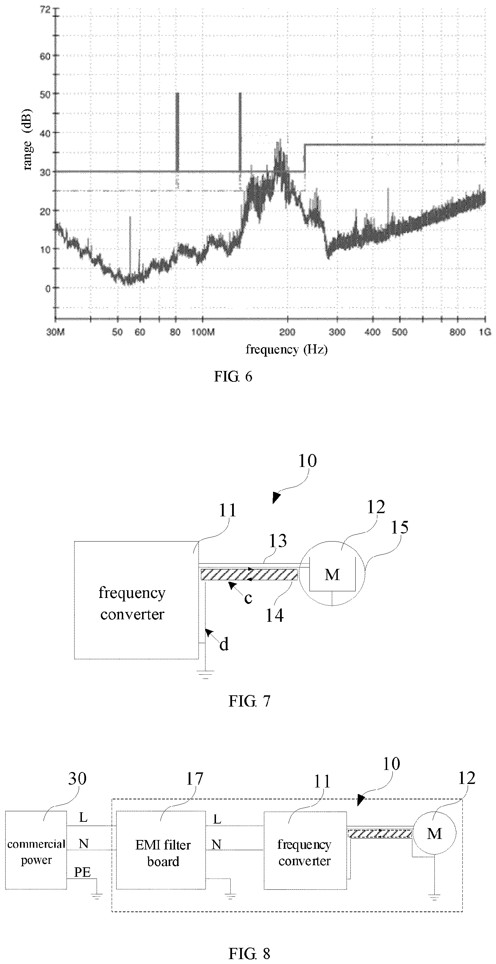

As shown in FIG. 5 and 6, FIG 5 is a view of the RE test results of the microwave oven in the embodiment of FIG 4, and FIG 6 is a view of RE test results of the microwave oven as shown in FIG 2. Obviously, it should be found that the RE of the microwave oven 10 of this embodiment is significantly reduced compared to a technical solution that the ground end of the frequency converter is connected directly to the ground and the ground end of the magnetron is connected directly to the ground.

In some embodiments, it should be understood that each pin of the magnetron and each pin of the frequency converter can also have other setting locations, and the magnetron and the frequency converter can also have other relative position relationships, which will not be repeated here.

In another embodiment, as shown in FIG 7, a difference between the microwave oven 10 of this embodiment and the microwave oven 10 as described above is that the ground end of the frequency converter 11 is grounded, the ground end of the magnetron 12 is connected to the housing 15 of the magnetron 12, and the housing 15 of the magnetron 12 is connected to the ground end of the frequency converter 11 via the second conductor 14.

In some embodiments, the second conductor 14 includes a first section c and a second section d, and the housing 15 of the magnetron 12 is connected to the second section d of the second conductor 14 via the first section c of the second conductor 14, the second section d of the second conductor 14 is routed from the power supply end of the frequency converter 11 to the ground end of the frequency converter 11, and the first section c of the second conductor 14 is arranged in parallel to the first conductor 13.

In another embodiment, as shown in FIG 8, based on the microwave oven 10 in the embodiment of FIG 1, the microwave oven 10 in this embodiment further includes an Electro Magnetic Interference (EMI) filter board 17. Further, an input end of the EMI filter board 17 is connected to the commercial power 30, an output end of the EMI filter board 17 is connected to an input end of the frequency converter 11, and the EMI filter board 17 is configured to filter the commercial power 30 to filter out high-frequency interference in the commercial power 30, and the like.

After the commercial power 30 is supplied to the power supply, the commercial power 30 firstly passes through the EMI filter board 17. The EMI filter board 17 is mainly configured to filter the interference of high-frequency pulses of an external power grid to the power supply, and reduce the electromagnetic interference of the power supply to the outside world at the same time.

The EMI filter board 17 may be implemented as capacitors and inductors.

Different from the related art, the microwave oven 10 according to some embodiments of the present disclosure includes the frequency converter 11, the magnetron 12, the first conductor 13, and the second conductor 14. The power supply end of the frequency converter 11 is connected to the power supply end of the magnetron 12 via the first conductor 13, and the ground end of the frequency converter 11 is connected to the ground end of the magnetron 12 via the second conductor 14. The first conductor 13 and the part of the second conductor 14 are arranged in parallel, and the distance between the first conductor 13 and the part of the second conductor 14 is less than the preset distance. In this way, the first conductor 13 as the cathode wire and the part of the second conductor 14 as the ground wire are arranged in parallel in some embodiments of the present disclosure, so as to reduce a distance between the cathode wire and the ground wire, and then reduce the area of the closed loop 16 formed by the cathode wire and the ground wire, thus reducing the RE of the microwave oven 10 to make the microwave oven 10 meet the EMC standards.

The above are only embodiments of the present disclosure and are not intended to limit the scope of the present disclosure.

## Claims

1. A microwave oven (10), comprising:
a frequency converter (11);
a magnetron (12);
a first conductor (13), wherein a power supply end of the frequency converter (11) is connected to a power supply end of the magnetron (12) via the first conductor (13); and
a second conductor (14), wherein a ground end of the frequency converter (11) is connected to a ground end of the magnetron (12) via the second conductor (14);
wherein the first conductor (13) and a part of the second conductor (14) are arranged in parallel, and a distance between the first conductor (13) and the part of the second conductor (14) is less than a preset distance.

2. The microwave oven (10) as claimed in claim 1, wherein a housing (15) of the magnetron (12) is grounded, the ground end of the magnetron (12) is connected to the housing (15) of the magnetron (12), and the ground end of the frequency converter (11) is connected to the housing (15) of the magnetron (12) via the second conductor (14).

3. The microwave oven (10) as claimed in claim 2, wherein the second conductor (14) comprises:
a first section (a), wherein the first section (a) of the second conductor (14) is routed from the ground end of the frequency converter (11) to the power supply end of the frequency converter (11); and
a second section (b), wherein the ground end of the frequency converter (11) is connected to the second section (b) of the second conductor (14) via the first section (a) of the second conductor (14), and the second section (b) of the second conductor (14) arranged in parallel to the first conductor (13).

4. The microwave oven (10) as claimed in claim 1, wherein the ground end of the frequency converter (11) is grounded, the ground end of the magnetron (12) is connected to a housing (15) of the magnetron (12), and the housing (15) of the magnetron (12) is connected to the ground end of the frequency converter (11) via the second conductor (14).

5. The microwave oven (10) as claimed in claim 4, wherein the second conductor (14) comprises:
a first section (a), wherein the first section (a) of the second conductor (14) is arranged in parallel to the first conductor (13); and
a second section (b), wherein the second section (b) of the second conductor (14) is routed from the power supply end of the frequency converter (11) to the ground end of the frequency converter (11), and the housing (15) of the magnetron (12) is connected to the second section (b) of the second conductor (14) via the first section (a) of the second conductor (14).

6. The microwave oven (10) as claimed in claim 2, wherein the housing (15) of the magnetron (12) is arranged with a ground point (152), and the ground end of the frequency converter (11) is connected to the ground point (152) via the second conductor (14).

7. The microwave oven (10) as claimed in claim 6, wherein the power supply end of the magnetron (12) is arranged on a first side of the magnetron (12), the ground point (152) is arranged on a second side of the magnetron (12), the ground end of the frequency converter (11) is arranged on a first side of the frequency converter (11), and the power supply end of is arranged on a second side of the frequency converter (11);
wherein a third side of the magnetron (12) is arranged opposite to the second side of the frequency converter (11), the first side of the magnetron (12) and the first side of the frequency converter (11) are arranged on a same side, and the second side of the magnetron (12) is arranged opposite to the third side of the magnetron (12).

8. The microwave oven (10) as claimed in claim 1, wherein a sleeve is sleeved on the first conductor (13).

9. The microwave oven (10) as claimed in claim 1, wherein the first conductor (13) and the second conductor (14) are bound with each other.

10. The microwave oven (10) as claimed in claim 1, wherein the distance between the first conductor (13) and the part of the second conductor (14) is less than a distance between the power supply end of the frequency converter (11) and the ground end of the frequency converter (11).

## Patentansprüche

1. Mikrowellenherd (10), der Folgendes aufweist:
einen Frequenzumrichter (11);
ein Magnetron (12);
einen ersten Leiter (13), wobei eine Stromversorgungsseite des Frequenzumrichters (11) über den ersten Leiter (13) mit einer Stromversorgungsseite des Magnetrons (12) verbunden ist; und
einen zweiten Leiter (14), wobei eine Erdungsseite des Frequenzumrichters (11) über den zweiten Leiter (14) mit einer Erdungsseite des Magnetrons (12) verbunden ist;
wobei der erste Leiter (13) und ein Teil des zweiten Leiters (14) parallel angeordnet sind und ein Abstand zwischen dem ersten Leiter (13) und dem Teil des zweiten Leiters (14) kleiner als ein vorgegebener Abstand ist.

2. Mikrowellenherd (10) nach Anspruch 1, wobei ein Gehäuse (15) des Magnetrons (12) geerdet ist, die Erdungsseite des Magnetrons (12) mit dem Gehäuse (15) des Magnetrons (12) verbunden ist und die Erdungsseite des Frequenzumrichters (11) über den zweiten Leiter (14) mit dem Gehäuse (15) des Magnetrons (12) verbunden ist.

3. Mikrowellenherd (10) nach Anspruch 2, wobei der zweite Leiter (14) Folgendes aufweist:
einen ersten Abschnitt (a), wobei der erste Abschnitt (a) des zweiten Leiters (14) von der Erdungsseite des Frequenzumrichters (11) zur Stromversorgungsseite des Frequenzumrichters (11) geführt ist; und
einen zweiten Abschnitt (b), wobei die Erdungsseite des Frequenzumrichters (11) über den ersten Abschnitt (a) des zweiten Leiters (14) mit dem zweiten Abschnitt (b) des zweiten Leiters (14) verbunden ist und der zweite Abschnitt (b) des zweiten Leiters (14) parallel zu dem ersten Leiter (13) angeordnet ist.

4. Mikrowellenherd (10) nach Anspruch 1, wobei die Erdungsseite des Frequenzumrichters (11) geerdet ist, die Erdungsseite des Magnetrons (12) mit einem Gehäuse (15) des Magnetrons (12) verbunden ist und das Gehäuse (15) des Magnetrons (12) über den zweiten Leiter (14) mit der Erdungsseite des Frequenzumrichters (11) verbunden ist.

5. Mikrowellenherd (10) nach Anspruch 4, wobei der zweite Leiter (14) Folgendes aufweist:
einen ersten Abschnitt (a), wobei der erste Abschnitt (a) des zweiten Leiters (14) parallel zum ersten Leiter (13) angeordnet ist; und
einen zweiten Abschnitt (b), wobei der zweite Abschnitt (b) des zweiten Leiters (14) von der Stromversorgungsseite des Frequenzumrichters (11) zur Erdungsseite des Frequenzumrichters (11) geführt ist und das Gehäuse (15) des Magnetrons (12) über den ersten Abschnitt (a) des zweiten Leiters (14) mit dem zweiten Abschnitt (b) des zweiten Leiters (14) verbunden ist.

6. Mikrowellenherd (10) nach Anspruch 2, wobei das Gehäuse (15) des Magnetrons (12) mit einem Erdungspunkt (152) angeordnet ist und die Erdungsseite des Frequenzumrichters (11) über den zweiten Leiter (14) mit dem Erdungspunkt (152) verbunden ist.

7. Mikrowellenherd (10) nach Anspruch 6, wobei die Stromversorgungsseite des Magnetrons (12) an einer ersten Seite des Magnetrons (12) angeordnet ist, der Erdungspunkt (152) an einer zweiten Seite des Magnetrons (12) angeordnet ist, die Erdungsseite des Frequenzumrichters (11) an einer ersten Seite des Frequenzumrichters (11) angeordnet ist und die Stromversorgungsseite des [*Lakune*] an einer zweiten Seite des Frequenzumrichters (11) angeordnet ist;
wobei eine dritte Seite des Magnetrons (12) der zweiten Seite des Frequenzumrichters (11) entgegengesetzt angeordnet ist, die erste Seite des Magnetrons (12) und die erste Seite des Frequenzumrichters (11) auf einer gleichen Seite angeordnet sind und die zweite Seite des Magnetrons (12) der dritten Seite des Magnetrons (12) entgegengesetzt angeordnet ist.

8. Mikrowellenherd (10) nach Anspruch 1, wobei eine Hülse auf den ersten Leiter (13) aufgehülst ist.

9. Mikrowellenherd (10) nach Anspruch 1, wobei der erste Leiter (13) und der zweite Leiter (14) aneinandergebunden sind.

10. Mikrowellenherd (10) nach Anspruch 1, wobei der Abstand zwischen dem ersten Leiter (13) und dem Teil des zweiten Leiters (14) kleiner als ein Abstand zwischen der Stromversorgungsseite des Frequenzumrichters (11) und der Erdungsseite des Frequenzumrichters (11) ist.

## Revendications

1. Four à micro-ondes (10), comprenant :
un convertisseur de fréquence (11) ;
un magnétron (12) ;
un premier conducteur (13), dans lequel une extrémité d'alimentation électrique du convertisseur de fréquence (11) est connectée à une extrémité d'alimentation électrique du magnétron (12) par l'intermédiaire du premier conducteur (13) ; et
un second conducteur (14), dans lequel une extrémité de terre du convertisseur de fréquence (11) est connectée à une extrémité de terre du magnétron (12) par l'intermédiaire du second conducteur (14) ;
dans lequel le premier conducteur (13) et une partie du second conducteur (14) sont agencés en parallèle, et une distance entre le premier conducteur (13) et la partie du second conducteur (14) est inférieure à une distance prédéfinie.

2. Four à micro-ondes (10) selon la revendication 1, dans lequel un logement (15) du magnétron (12) est mis à la terre, l'extrémité de terre du magnétron (12) est connectée au logement (15) du magnétron (12), et l'extrémité de terre du convertisseur de fréquence (11) est connectée au logement (15) du magnétron (12) par l'intermédiaire du second conducteur (14).

3. Four à micro-ondes (10) selon la revendication 2, dans lequel le second conducteur (14) comprend :
une première section (a), dans lequel la première section (a) du second conducteur (14) est acheminée de l'extrémité de terre du convertisseur de fréquence (11) à l'extrémité d'alimentation électrique du convertisseur de fréquence (11) ; et
une seconde section (b), dans lequel l'extrémité de terre du convertisseur de fréquence (11) est connectée à la seconde section (b) du second conducteur (14) par l'intermédiaire de la première section (a) du second conducteur (14), et la seconde section (b) du second conducteur (14) étant agencée en parallèle au premier conducteur (13).

4. Four à micro-ondes (10) selon la revendication 1, dans lequel l'extrémité de terre du convertisseur de fréquence (11) est mise à la terre, l'extrémité de terre du magnétron (12) est connectée à un logement (15) du magnétron (12), et le logement (15) du magnétron (12) est connecté à l'extrémité de terre du convertisseur de fréquence (11) par l'intermédiaire du second conducteur (14).

5. Four à micro-ondes (10) selon la revendication 4, dans lequel le second conducteur (14) comprend :
une première section (a), dans lequel la première section (a) du second conducteur (14) est agencée en parallèle au premier conducteur (13) ; et
une seconde section (b), dans lequel la seconde section (b) du second conducteur (14) est acheminée à partir de l'extrémité d'alimentation électrique du convertisseur de fréquence (11) à l'extrémité de terre du convertisseur de fréquence (11), et le logement (15) du magnétron (12) est connecté à la seconde section (b) du second conducteur (14) par l'intermédiaire de la première section (a) du second conducteur (14).

6. Four à micro-ondes (10) selon la revendication 2, dans lequel le logement (15) du magnétron (12) est agencé avec un point de terre (152), et l'extrémité de terre du convertisseur de fréquence (11) est connectée au point de terre (152) par l'intermédiaire du second conducteur (14).

7. Four à micro-ondes (10) selon la revendication 6, dans lequel l'extrémité d'alimentation électrique du magnétron (12) est agencée sur un premier côté du magnétron (12), le point de terre (152) est agencé sur un deuxième côté du magnétron (12), l'extrémité de terre du convertisseur de fréquence (11) est agencée sur un premier côté du convertisseur de fréquence (11), et l'extrémité d'alimentation électrique du est agencée sur un deuxième côté du convertisseur de fréquence (11) ;
dans lequel un troisième côté du magnétron (12) est agencé en regard du deuxième côté du convertisseur de fréquence (11), le premier côté du magnétron (12) et le premier côté du convertisseur de fréquence (11) sont agencés sur un même côté, et le deuxième côté du magnétron (12) est agencé en regard du troisième côté du magnétron (12).

8. Four à micro-ondes (10) selon la revendication 1, dans lequel une gaine est emmanchée sur le premier conducteur (13).

9. Four à micro-ondes (10) selon la revendication 1, dans lequel le premier conducteur (13) et le second conducteur (14) sont reliés l'un à l'autre.

10. Four à micro-ondes (10) selon la revendication 1, dans lequel la distance entre le premier conducteur (13) et la partie du second conducteur (14) est inférieure à une distance entre l'extrémité d'alimentation électrique du convertisseur de fréquence (11) et l'extrémité de terre du convertisseur de fréquence (11).
